## Europäisches Patentamt

## European Patent Office

## Office européen des brevets

(11) Publication number: **0 079 220**
**B1**

(12)

# EUROPEAN PATENT SPECIFICATION

(45) Date of publication of patent specification: **03.08.88**

(51) Int. Cl.⁴: **G 11 C 11/24**

(21) Application number: **82305911.8**

(22) Date of filing: **05.11.82**

(54) Semiconductor memory devices.

(30) Priority: **05.11.81 JP 177477/81**

(43) Date of publication of application:
**18.05.83 Bulletin 83/20**

(45) Publication of the grant of the patent:
**03.08.88 Bulletin 88/31**

(84) Designated Contracting States:
**DE FR GB**

(56) References cited:
**EP-A-0 037 227**
**EP-A-0 037 233**

(73) Proprietor: **FUJITSU LIMITED**
**1015, Kamikodanaka Nakahara-ku**
**Kawasaki-shi Kanagawa 211 (JP)**

(72) Inventor: **Nozaki, Shigeki**
**Mezon Hisasue 203 413-4, Hisasue Takatsu-ku**
**Kawasaki-shi Kanagawa 213 (JP)**
Inventor: **Takemae, Yoshihiro**
**1-20-5-9-301, Utsukushigaoka Midori-ku**
**Yokohama-shi Kanagawa 227 (JP)**
Inventor: **Nakano, Tomio**
**1-11-2-12-404, Shirahatadai Miyamae-ku**
**Kawasaki-shi Kanagawa 213 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

Courier Press, Leamington Spa, England.

## Description

The present invention relates to semiconductor memory devices, and can be particularly relevant to a metal-insulator semiconductor (MIS) dynamic memory device.

To increase the degree of integration of a semiconductor memory device, it is necessary to use the chip area of the integrated circuit of the semiconductor memory device more effectively. In an attempt to do this, a recently proposed MIS dynamic memory device adopts a system in which two sense amplifiers are selected by one decoder circuit, instead of using a system in which one decoder circuit selects one sense amplifier.

However, even in such a memory device using a system in which two sense amplifiers are selected by a single decoder circuit, the area occupied by the decoder circuits on a semiconductor substrate becomes relatively large when the memory capacity is large, thereby making it difficult to further increase the degree of integration of the semiconductor memory device.

It is thus desirable to decrease the area occupied by the decoder circuits on a semiconductor substrate of a semiconductor memory device and so increase the degree of integration possible.

According to the present invention, there is provided a semiconductor memory device comprising a semiconductor substrate having formed thereon an array of sense amplifiers, connected to respective pairs of bit lines, and a plurality of address decoders, each of which comprises a decoding portion, for decoding address signals supplied thereto by way of common address selection lines of the device, and two clamping portions for clamping respective output signals of the said decoding portion, the said plurality of address decoders being arranged along the array of sense amplifiers, different address decoders being associated respectively with different groups of the sense amplifiers and being each selectable individually, by way of the said common address selection lines, thereby to select the associated group of sense amplifiers,

characterised in that each of the said groups comprises a plurality of sets of different sense amplifiers, the different sets of sense amplifiers being operatively associated respectively with different data buses of the device, and in that the device includes common control lines, at least one of which is disposed to one side of the said array of sense amplifiers and another of which is disposed to the other side of that array whereby corresponding respective sense amplifiers in the different sets of the selected group can be selected simultaneously, so that the respective outputs of those selected sense amplifiers are applied simultaneously to the associated respective data buses, and in that the device further includes a plurality of pairs of common internal lines operatively associated with respective ones of the address decoders, each of which pairs is connected for transferring the said output signals of the decoding portion of the address decoder associated therewith to the respective clamping portions thereof and is so arranged that the respective lines of that pair are disposed on both sides of the said sense amplifiers of the sense amplifier group associated with the address decoder concerned.

Reference will now be made, by way of example, to the accompanying drawings, in which:

Figure 1 is a block circuit diagram of part of a previously-proposed MIS dynamic memory device;

Figure 2 is a schematic block diagram of circuitry in a semiconductor memory device embodying the present invention;

Figure 3 is a block circuit diagram illustrating details of the semiconductor memory device of Fig. 2; and

Figure 4 is a block circuit diagram of circuitry in a semiconductor memory device as another embodiment of the present invention.

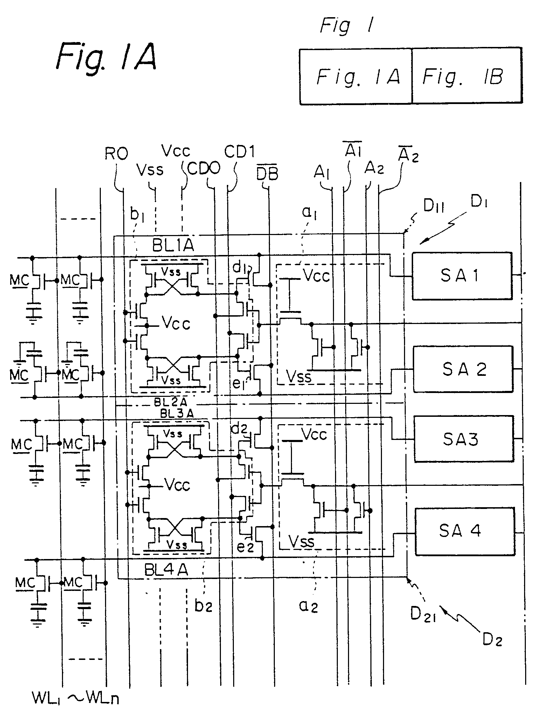

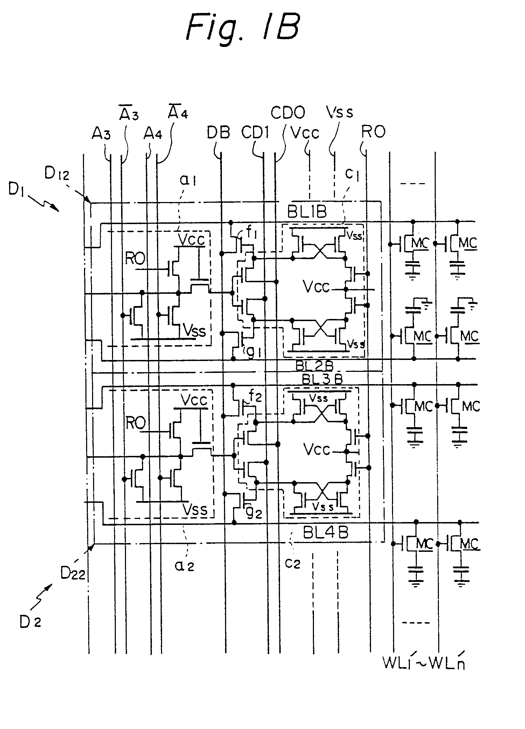

Figure 1 illustrates a previously-proposed semiconductor memory device in which one of two sense amplifiers is selected by a column decoder. In Fig. 1, SA1 to SA4 are sense amplifiers to which bits lines BL1A and BL1B to BL4A and BL4B are connected, respectively. WL1 to WLn and WL1' to WLn' are word lines, and between each of these word lines and each of the bit lines BL1A, BL1B, BL2A, BL2B, - - -, BL4A, BL4B, a memory cell MC consisting of an MIS transistor and a capacitor is connected. D1 and D2 are column decoders which select one of the sense amplifiers SA1 and SA2 and one of the sense amplifiers SA3 and SA4, respectively. The column decoder D1 comprises two separate portions D11 and D12, and the column decoder D2 comprises two separate portions D21 and D22. The portion D11 of the column decoder D1 and the portion D21 of the column decoder D2 are disposed on one side of the sense amplifiers and the portion D12 of the column decoder D1 and the portion D22 of the column decoder D2 are disposed on the other side of the sense amplifiers SA1, SA2, SA3, and SA4. To these decoders D1 and D2, column address lines A1, $\overline{A1}$, A2, $\overline{A2}$, A3, $\overline{A3}$, A4 and $\overline{A4}$ and column-selecting signals CD0 and CD1 are connected. The column-selecting signals CD0 and CD1 are activated by column address signals A0 and $\overline{A0}$, respectively, which are not shown in Fig. 1. DB and $\overline{DB}$ are data buses for transferring read-out or write-in data. R0 is a reset signal line, and Vcc and Vss are power supply lines.

The column decoder D1 comprises a decoding portion a1 divided into two circuit sections, one of the circuit sections being disposed in the portion D11 and the other circuit section being disposed in the portion D12, and a clamping portion b1 and a clamping portion c1 disposed in the portion D11 and the portion D12, respectively. The column decoder D2 comprises a decoding portion a2 divided into two circuit sections, one of the circuit sections being disposed in the portion D21 and the other circuit section being disposed in the portion D22, and a clamping portion b2 and a clamping portion c2 disposed in the portion D21 and the portion D22, respectively.

In the circuit of Fig. 1, when the output signal of the decoding portion a1 of the column decoder D1 is high, i.e. when the column decoder D1 is selected by column address signals supplied thereto, transfer gate transistors d1 and f1 or transfer gate transistors e1 and g1 are turned on in dependence upon whether signal CD0 or CD1 is high. If the column-selecting signal CD0 is high, the transfer gate transistors d1 and f1 are turned on and the bit lines BL1A and BL1B are connected to the data buses $\overline{DB}$ and DB, respectively. Thereby the sense amplifier SA1 is selected. If the column-selecting signal CD1 is high, the transfer gate transistors e1 and g1 are turned on and the bit lines BL2A and BL2B are connected to the data buses $\overline{DB}$ and DB, respectively. Thereby, the sense amplifier SA2 is selected.

When the output signal of the decoding portion a2 of the column decoder D2 is high, i.e. when the column decoder D2 is selected, the sense amplifier SA3 or SA4 is selected, in dependence upon whether signal CD0 or CD1 is high, in a manner similar to the case of the column decoder D1.

However, in the above-mentioned conventional memory device, since each column decoder selects only one of two sense amplifiers, it is necessary to use a relatively large number of column decoders when the memory capacity is large, thereby making it difficult to further increase the degree of integration of the semiconductor memory device.

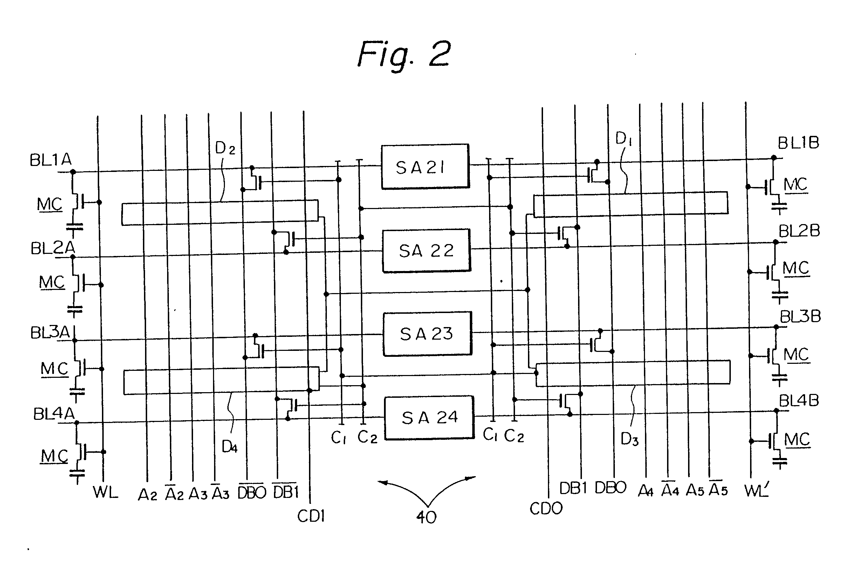

Figure 2 illustrates a schematic layout of the sense amplifiers, column decoders, etc. in a MIS dynamic memory device embodying the present invention. In the figure, SA21, SA22, SA23, and SA24, are sense amplifiers. To both sides of the sense amplifiers SA21, SA22, SA23, and SA24, bit lines BL1A and BL1B, BL2A and BL2B, BL3A and BL3B, and BL4A and BL4B are connected, respectively. Reference numeral 40 designates a column decoder which selects between the sense amplifiers SA21, SA22, SA23, and SA24. The column decoder 40 comprises four circuit blocks D1, D2, D3, and D4, the circuit blocks D1 and D3 being disposed on one side of, i.e. the right side of, and the circuit blocks D2 and D4 being disposed on the other side of, i.e. the left side of, the arrayed sense amplifiers SA21 through SA24. To the column decoder 40, column address lines A2, $\overline{A2}$, A3, $\overline{A3}$, A4, $\overline{A4}$, A5, $\overline{A5}$, and column-selecting signals CD0 and CD1 are connected. The column-selecting signals CD0 and CD1 are activated by column address signals A0 and $\overline{A0}$, respectively, which are not shown in Fig. 2. In the description below, A2 and $\overline{A2}$ to A5 and $\overline{A5}$ designate both the column address lines and the column address signals.

In Fig. 2, C1 and C2 are common internal lines disposed on both sides of the arrayed sense amplifiers SA21, SA22, SA23, SA24, - - - parallel thereto. The common internal lines C1 and C2 deliver control signals to gate elements for connecting the bit lines and data buses.

DB0, DB1, $\overline{DB0}$ and $\overline{DB1}$ are data buses which transfer data on the bit lines, which data is read out with the aid of the sense amplifiers, to a read-out circuit (not shown in Fig. 2). The data bus pair DB0, $\overline{DB0}$ is operatively associated with the set SA21 and SA22 of sense amplifiers of the group and the data bus pair DB1, $\overline{DB1}$ is operatively associated with the set SA23, SA24 of sense amplifiers of the group. WL and WL' are word lines, and between each of the word lines WL and WL' and each of the bit lines BL1A, BL1B, BL2A, BL2B, - - - -, BL4A, BL4B, a memory cell MC comprising an MIS transistor and a capacitor is connected. Each of the word lines WL and WL' is selected and activated by a row decoder circuit (not shown in Fig. 2).

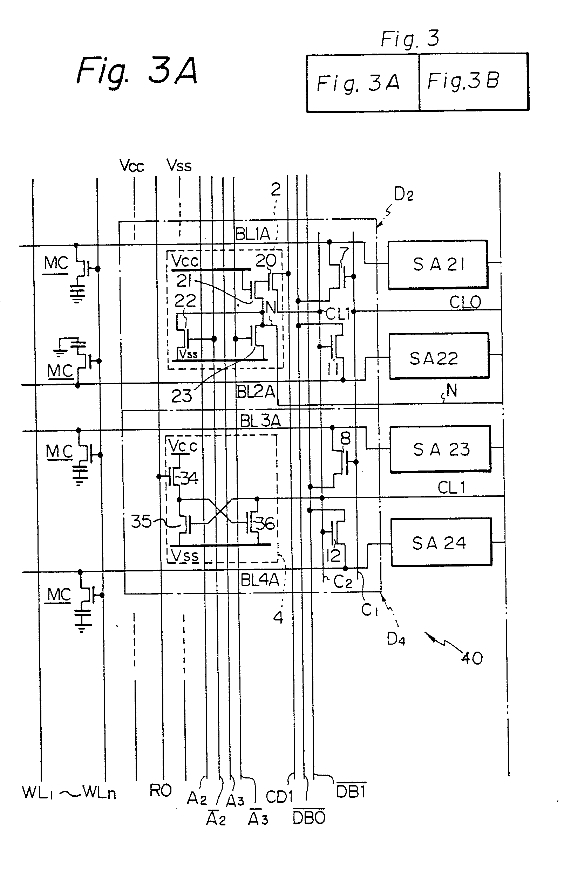

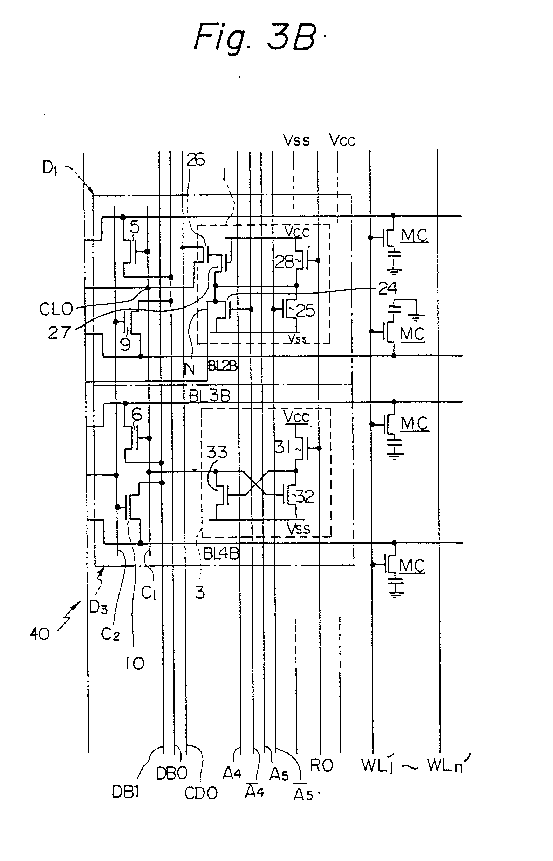

Figure 3 illustrates in detail a circuit of the circuit structure which is schematically shown in Fig. 2. In Fig. 3, the parts which are the same as those in Fig. 2 are designated by the same reference symbols as those in Fig. 2. Therefore, an explanation thereof is omitted here.

As illustrated in Fig. 3, the column decoder 40 is divided into four circuit sections, one section being formed in each of the four circuit blocks D1, D2, D3 and D4. Decoding portions 1 and 2 of the column decoder 40 are disposed in the circuit blocks D1 and D2, respectively. The decoding portions 1 and 2 comprise MIS transistors 24 to 28 and 20 to 23, respectively. The transistors 22 to 25 and 28 constitute a NOR gate to which column address signals, for example $\overline{A2}$, $\overline{A3}$, $\overline{A4}$ and $\overline{A5}$, are supplied. A clamping portion 3 of the column decoder 40 formed in the circuit block D3 comprises an MIS transistor 31 and cross-coupled MIS transistors 32 and 33. Another clamping portion 4 of the column decoder 40 formed in the circuit block D4 comprises an MIS transistor 34 and cross-coupled MIS transistors 35 and 36. The clamping portion 3 is used for clamping the output signal from the decoding portion 1, i.e. the signal on a bypass line CL0 connected to the common internal line C1. The clamping portion 4 is used for clamping the output signal from the decoding portion 2, i.e. the signal on a bypass line CL1 connected to the common internal line C2.

The signal on the line CL0, which signal becomes high when the column-selecting signal CD0 is high and the transistor 26 is in a turned on state, is supplied to the gate electrodes of transfer gate elements, i.e. MIS transistors 5, 6, 7, and 8 disposed in the circuit blocks D1, D3, D2, and D4, respectively, through the common internal line C1. The signal on the line CL1, which signal becomes high when the column-selecting signal CD1 is high and the transistor 20 is in a turned on state, is also supplied to the gate electrodes of transfer gate elements, i.e. MIS transistors 9, 10, 11, and 12 disposed in the circuit blocks D1, D3, D2, and D4, respectively, through the common internal line C2.

Operation of the circuit, embodying the present invention, having the above-mentioned structure will now be explained. When the column address signals are supplied to the decoding portions 1 and 2 so that the potential of a node N, i.e. the potential of the output of the NOR gate in the decoding portions 1 and 2, becomes high, i.e. when the column decoder 40 is selected, the transistors 26 and 20 are both turned on. In this condition, if the column-selecting signal CD0, which is, for example, the column address signal A0, is high, the output signal on the line CL0 becomes high. Therefore, the transfer gate elements 5, 6, 7, and 8 are turned on. At this time, if energization of a selected word line and operation of the sense amplifiers SA21 and SA23, corresponding to the transfer gate elements 5, 7 and 6, 8, respectively, are performed and the read-out signals from selected memory cells are generated on the bit lines BL1A, BL1B and BL3A, BL3B, the signals on the bit lines—BL1A and BL1B are transferred to the data buses $\overline{DB0}$ and DB0 through the transfer gate elements 7 and 5, respectively, and the signals on the bit lines BL3A and BL3B are transferred to the data buses $\overline{DB1}$ and DB1 through the transfer gate elements 8 and 6, respectively.

In the above-mentioned condition, if the column-selecting signal CD1, which is, for example, the column address signal $\overline{A0}$ and which is complementary to the signal CD0, is high, the output signal on the line CL1 becomes high. Therefore, the transfer gate elements 9, 11, 10, and 12 are turned on. At this time, if energization of a selected word line and operation of the sense amplifiers SA22 and SA24, corresponding to the gate elements 9, 11 and 10, 12, respectively, are performed and the readout signals from selected memory cells are generated on the bit lines BL2A, BL2B and BL4A, BL4B, the signals on the bit lines BL2A and BL2B are transferred to the data buses $\overline{DB0}$ and DB0 through the transfer gate elements 11 and 9, respectively, and the signals on the bit lines BL4A and BL4B are transferred to the data buses $\overline{DB1}$ and DB1 through the transfer gate elements 12 and 10, respectively.

In the above-mentioned embodiment, the signals transferred to the data buses $\overline{DB0}$, DB0 and $\overline{DB1}$, DB1 are simultaneously output as a two-bit read-out signal through an output buffer circuit (not shown in Fig. 3). However, it is also possible to output only a one-bit readout signal corresponding to the data bus pair $\overline{DB0}$ and DB0 or the data bus pair $\overline{DB1}$ and DB1. The selection of a one-bit output signal is performed, for example, in an output buffer circuit by column address signals $\overline{A1}$ and A1. In such a case, the output buffer comprises a buffer amplifier which is activated by the column address signal $\overline{A1}$ and to which the signals from the bit line pair $\overline{DB0}$ and DB0 are supplied, another buffer amplifier which is activated by the column address signal A1 and to which the signals from the bit line pair $\overline{DB1}$ and DB1 are supplied, and an OR gate which receives the output signals from these two buffer amplifiers.

As mentioned above, in the circuit of Figs. 2 and 3, it is possible to select one of the sense amplifiers SA21, SA22, SA23, and SA24 by using a single column decoder 40, and it is not necessary to change the structure of the column decoder 40. Therefore, the area occupied by the column decoders on a semiconductor substrate of a memory device embodying the present invention can be half that of a conventional memory device in which one of two sense amplifiers is selected by a single column decoder. In the memory device embodying the present invention, since all the circuit elements necessary for the column decoders are formed in a reduced area, it is possible to use the area thereby freed for the formation of other circuits, such as other decoder circuits or memory cells. Therefore, it is possible to increase the degree of integration of the memory device.

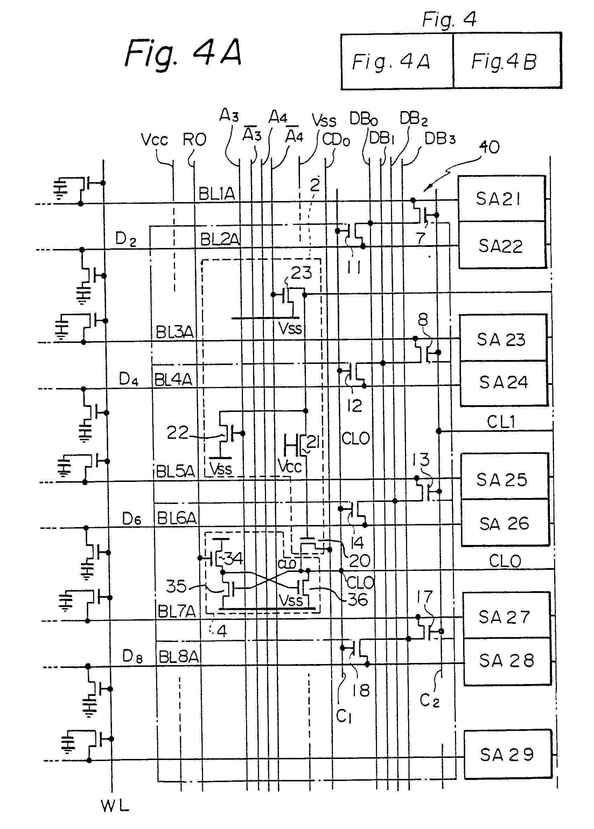

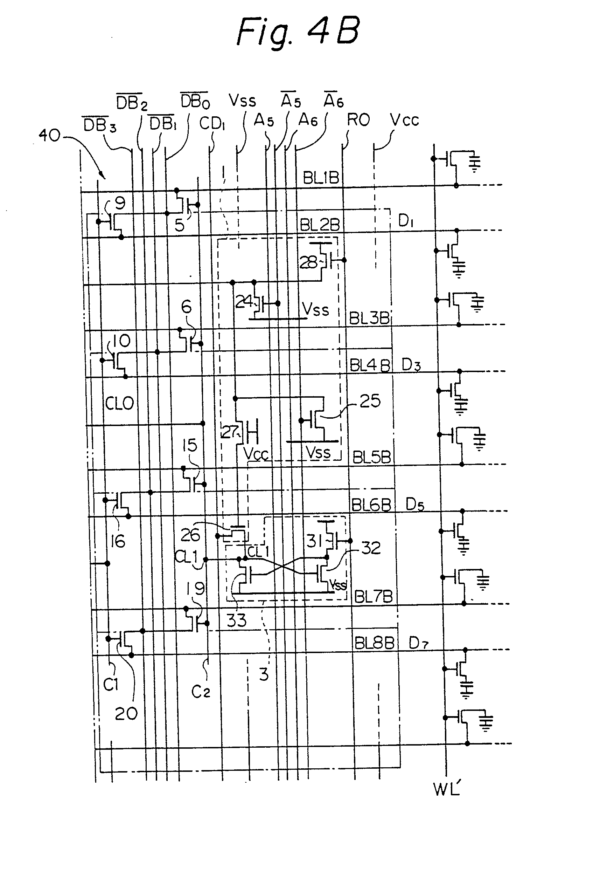

Figure 4 is a detailed circuit diagram illustrating another embodiment of the present invention. The circuit of Fig. 4 differs from the circuit of Fig. 3 in that in the circuit of Fig. 4, a single column decoder is provided for eight sense amplifiers SA21, SA22, - - -, SA28. The circuit of Fig. 4 also differs from the circuit of Fig. 3 in that it comprises: eight data buses DB0, $\overline{DB0}$, DB1, $\overline{DB1}$, DB2, $\overline{DB2}$, DB3, and $\overline{DB3}$ instead of four data buses and eight sense amplifiers SA21, SA22, - - -, SA28 for each column decoder 40 instead of four sense amplifiers, the eight sense amplifiers SA21, SA22, - - -, SA28 being connected to pairs of bit lines BL1A and BL1B, BL2A and BL2B, - - -, BL8A and BL8B, respectively. Between the bit lines BL5A and BL6A and the data bus DB2, gate elements 13 and 14 are connected, respectively. Between the bit lines BL5B and BL6B and the data bus $\overline{DB2}$, gate elements 15 and 16 are connected, respectively. Between the bit lines BL7A and BL8A and the data bus DB3, gate elements 17 and 18 are connected. Between the bit lines BL7B and BL8B and the data bus $\overline{DB3}$, gate elements 19 and 20 are connected. Between the bit lines BL1A and BL2A and the data bus DB0, between the bit lines BL1B and BL2B and the data bus $\overline{DB0}$, between the bit lines BL3A and BL4A and the data bus DB1, and between the bit lines BL3B and BL4B and the data bus $\overline{DB1}$, the gate elements 7 and 11, 5 and 9, 8 and 12, and 6 and 10 are connected, respectively, in a manner similar to that of the circuit of Fig. 3. The column decoder 40 is divided into six circuit sections, one section being formed in each of the six circuit blocks D1, D2, - - -, D6. A decoding portion 1 is divided into two circuit sections formed in the adjacent circuit blocks D1 and D3, and another decoding portion 2 is divided into circuit sections formed in the adjacent circuit blocks D2 and D4. A clamping portion 3 is formed in the circuit block D5 and another clamping portion 4 is formed in the circuit block D6. Two more circuit blocks D7 and D8 can be used for forming other circuit elements, such as capacitors for stabilizing a power supply voltage. The other parts of Fig. 4 are the same as those of Fig. 3 and are designated by the same reference numbers and symbols as those in Fig. 3. Therefore, an explanation thereof is omitted here.

Operation of the circuit of Fig. 4 now is briefly described. When the decoding portion 1 is selected and the output signal CL1 thereof becomes high, the sense amplifiers SA21, SA23, SA25, and SA27 are selected and the signals on the bit lines BL1A, BL1B, BL3A, Bl3B, BL5A, BL5B, BL7A, and BL7B are transferred to the data buses DB0, $\overline{DB0}$, DB1, $\overline{DB1}$, DB2, $\overline{DB2}$, DB3, and $\overline{DB3}$ through the gate elements 7, 5, 8, 6, 13, 15, 17, and 19, respectively. When the decoding portion 2 is selected and the output signal CL0 thereof becomes high, the sense amplifiers SA22, SA24, SA26, and SA28 are selected and the signals on the bit lines BL2A, BL2B, BL4A, BL4B, BL6A, BL6B, BL8A, and BL8B are transferred to the data buses DB0, $\overline{DB0}$, DB1, $\overline{DB1}$, DB2, $\overline{DB2}$, DB3, and $\overline{DB3}$ through the gate elements 11, 9, 12, 10, 14, 16, 18, and 20, respectively.

The signals thus transferred to the data buses DB0, $\overline{DB0}$, DB1, - - -, $\overline{DB3}$ are supplied to an output buffer circuit (not shown) and are output therefrom as four bit read-out signals. It is also possible to output only one bit read-out signal from the output buffer circuit. In such a case, one of four bit signals is selected, depending on the column address signals, for example, A1 (or $\overline{A1}$) and A2 (or $\overline{A2}$), by gate circuits formed, for example, in the output buffer circuit.

As mentioned above, in the circuit of Fig. 4 is it possible to select one or more sense amplifiers from eight sense amplifiers with one column decoder 40, and therefore the area occupied on a semiconductor substrate by the column decoder 40 is very small. As a result, the column decoder 40 can be disposed in the circuit blocks D1, D2, D3, D4, D5, and D6 and the circuit blocks D7 and D8 can be used for forming other peripheral circuits, such as capacitors for stabilizing the power supply voltage and so on.

In the above-mentioned embodiments of Figs. 2 through 4, since the number of column decoders is small and each column decoder is divided into a plurality of circuit sections disposed on both sides of the sense amplifier array, the pitch length l of Fig. 2, i.e. the width of the column decoder area, is reduced. Therefore, the increased area on a semiconductor substrate due to a decrease in the length l can be used for forming, for example, memory cells, and the degree of integration of the memory device can further be increased.

## Claims

1. A semiconductor memory device comprising a semiconductor substrate having formed thereon an array of sense amplifiers (SA), connected to respective pairs of bit lines (BL), and a plurality of address decoders (40), each of which comprises a decoding portion (1, 2), for decoding address signals supplied thereto by way of common address selection lines (A) of the device, and two clamping portions (3, 4) for clamping respective output signals of the said decoding portion, the said plurality of address decoders (40) being arranged along the array of sense amplifiers (SA), different address decoders being associated respectively with different groups of the sense amplifiers and being each selectable individually; by way of the said common address selection lines (A), thereby to select the associated group of sense amplifiers, characterised in that each of the said groups comprises a plurality of sets (SA21/SA22, SA23/SA24) of different sense amplifiers, the different sets of. sense amplifiers being operatively associated respectively with different data buses (DB0, DB1) of the device, and in that the device includes common control lines (CD1, CD0), at least one of which (CDO) is disposed to one side of the said array of sense amplifiers (SA) and another of which (CD1) is disposed to the other side of that array, whereby corresponding respective sense amplifiers (SA21, SA23) in the different sets of the selected group can be selected simultaneously, so that the respective outputs of those selected sense amplifiers are applied simultaneously to the associated respective data buses (DB0, DB1), and in that the device further includes a plurality of pairs of common internal lines ($C_1$, CL0, $C_2$, CL1) operatively associated with respective ones of the address decoders (40), each of which pairs is connected for transferring the said output signals of the decoding portion (1, 2) of the address decoder (40) associated therewith to the respective clamping portions (3, 4) thereof and is so arranged that the respective lines of that pair are disposed on both sides of the said sense amplifiers (SA) of the sense amplifier group associated with the address decoder (40) concerned.

2. A semiconductor memory device as claimed in claim 1, wherein the said common control lines comprise two control signal lines (CD0, CD1), one of which is operatively associated with one of the sense amplifiers in each set and the other of which is operatively associated with another of the sense amplifiers in each set.

3. A semiconductor memory device as claimed in claim 2, wherein each of the said groups comprises two sets (SA21/SA22, SA23/SA24) of sense amplifiers, each such set comprising two sense amplifiers, and wherein an individual pair of the said data buses (DB0/$\overline{DB0}$, DB1/$\overline{DB1}$) is provided for each such set.

4. A semiconductor memory device as claimed in claim 2, wherein each of the said groups comprises four sets of sense amplifiers (Figure 4), each such set comprising two sense amplifiers, and wherein an individual pair of the said data buses is provided for each such set.

5. A semiconductor memory device as claimed in any preceding claim, wherein in each of the said address decoders (40) the respective decoding portion (1, 2) thereof is divided into two circuit sections, one of which sections is disposed to one side of the said array of sense amplifiers (SA) and the other of which sections is disposed to the other side of that array.

6. A semiconductor memory device as claimed in claim 5, wherein in each of the said address decoders (40) one of the respective clamping portions (3, 4) thereof is disposed to one side of the said array of sense amplifiers (SA) and the other of the said clamping portions is disposed to the other side of that array.

7. A semiconductor memory device as claimed in any preceding claim, wherein in each of the said address decoders (40) the respective decoding portion (1, 2) thereof comprises a decoding gate (22, 23, 24, 25, 28), to which the said address signals are supplied, and transfer gates (20, 26) which are controlled by an output signal from the said decoding gate.

8. A semiconductor memory device as claimed in claim 7, wherein the said decoding gate (22, 23, 24, 25, 28) is a NOR gate comprising a plurality of inverter transistors which are connected in parallel with one another and have respective gate electrodes connected to receive respective address signals.

9. A semiconductor memory device as claimed in claim 7 or 8, wherein control signals supplied to the said common control lines (CD) are transferred to the said clamping portions (3, 4) through the said transfer gates (20, 26), and output signals of the said clamping portions (3, 4) are supplied to control gates of respective gate elements (5 to 12) connected between respective ones of the said bit lines (BL) and respective data buses (DB) associated with those bit lines.

10. A semiconductor memory device as claimed in claim 9 when read as appended to claim 6, wherein the said output signals of the said clamping portions (3, 4) are supplied to the said control gates of respective gate elements (5 to 12) by way of bypass lines (CL0, CL1) disposed between the sense amplifiers (SA).

11. A semiconductor memory device as claimed in any preceding claim, wherein in each of the said address decoders (40) each of the said clamping portions (3, 4) thereof comprises transistors (32, 33, 35, 36) which are cross-coupled at the gates and drains thereof.

**Patentansprüche**

1. Halbleiterspeichervorrichtung mit einem Halbleitersubstrat, auf dem eine Anordnung von Leseverstärkern (SA) gebildet ist, die mit entsprechenden Paaren von Bitleitungen (BL) verbunden sind, und eine Vielzahl von Adreßdecodern (40), von denen jeder einen Decodierungsabschnitt (1, 2) umfaßt, zum Decodieren von Adreßsignalen, die ihm über gemeinsame Adreßauswahlleitungen (A) der Vorrichtung zugeführt werden, und zwei Klammerabschnitte (3, 4) zum Klammern jeweiliger Ausgangssignale des genannten Decodierungsabschnitts, wobei die genannte Vielzahl von Adreßdecodern (40) längs der Anordnung von Leseverstärkern (SA) angeordnet ist, verschiedene Adreßdecoder jeweils verschiedenen Gruppen von Leseverstärkern zugeordnet sind und jeweils mittels der genannten gemeinsamen Adreßauswahlleitungen (A) einzeln auswählbar sind, um dadurch die zugeordnete Gruppe von Leseverstärkern auszuwählen, dadurch gekennzeichnet, daß jede der genannten Gruppen eine Vielzahl von Sätzen (SA21/SA22, SA23/SA24) von verschiedenen Leseverstärkern umfaßt, welche verschiedenen Sätze von Leseverstärkern wirkungsmäßig jeweils verschiedenen Datenbussen (DB0, DB1) der Vorrichtung zugeordnet sind, und daß die Vorrichtung gemeinsame Steuerleitungen (CD1, CD0) umfaßt, von denen wenigstens (CD0) auf einer Seite der genannten Anordnung von Leseverstärkern (SA) und von denen eine andere (CD1) auf der anderen Seite der Anordnung angeordnet ist, wodurch entsprechende jeweilige Leseverstärker (SA21, SA23) in den verschiedenen Sätzen der ausgewählten Gruppe gleichzeitig ausgewählt werden können, so daß die jeweiligen Ausgänge jener ausgewählten Leseverstärker gleichzeitig den zugeordneten jeweiligen Datenbussen (DB0, DB1) zugefürt werden, und daß die Vorrichtung ferner eine Vielzahl von Paaren von gemeinsamen internen Leitungen (C1, CL0, C2, CL1) umfaßt, die wirkungsmäßig entsprechenden der Adreßdecoder (40) zugeordnet sind, von denen jedes Paar zum Übertragen der genannten Ausgangssignale des Decodierungsabschnitts (1, 2) des Adreßdecoders (40), welcher ihm zugeordnet ist, zu den jeweiligen Klammerschaltungen (3, 4) davon verbunden und so angeordnet ist, daß die jeweiligen Leitungen von jenem Paar auf beiden Seiten der genannten Leseverstärker (SA) der Leseverstärkergruppe angeordnet sind, welche dem betreffenden Adreßdecoder (40) zugeordnet ist.

2. Halbleiterspeichervorrichtung nach Anspruch 1, bei der die genannten gemeinsamen Steuerleitungen zwei Steuersignalleitungen (CD0, CD1) umfassen, von denen eine wirkungsmäßig einem der Leseverstärker in jedem Satz zugeordnet ist, und von denen die andere wirkungsmäßig einem anderen der Leseverstärker in jedem Satz zugeordnet ist.

3. Halbleiterspeichervorrichtung nach Anspruch 2, bei der jede der genannten Gruppen zwei Sätze (SA21/SA22, SA23/SA24) von Leseverstärkern umfaßt, von denen jeder solche Satz zwei Leseverstärker umfaßt, und bei der ein individuelles Paar der genannten Datenbusse (DB0/$\overline{DB0}$, DB1/$\overline{DB1}$) für jeden solchen Satz vorgesehen ist.

4. Halbleiterspeichervorrichtung nach Anspruch 2, bei der jede der genannten Gruppen vier Sätze von Leseverstärkern (Figur 4) umfaßt, von denen jeder solche Satz zwei Leseverstärker umfaßt, und bei der ein individuelles Paar der genannten Datenbusse für jeden solchen Satz vorgesehen ist.

5. Halbleiterspeichervorrichtung nach einem der vorhergehenden Ansprüche, bei der in jedem der genannten Adreßdecoder (40) der jeweilige Decodierungsabschnitt (1, 2) davon in zwei Schaltungsabschnitte unterteilt ist, von denen ein Abschnitt auf einer Seite der genannten Anordnung von Leseverstärkern (SA) angeordnet ist, und von denen der andere Abschnitt auf der anderen Seite der Anordnung angeordnet ist.

6. Halbleiterspeichervorrichtung nach Anspruch 5, bei der in jedem der genannten Adreßdecoder (40) eine der jeweiligen Klammerschaltungen (3, 4) davon auf einer Seite der genannten Anordnung von Leseverstärkern (SA) angeordnet ist und der andere der genannten Klammerabschnitte auf der anderen Seite von jener Anordnung angeordnet ist.

7. Halbleiterspeichervorrichtung nach einem der vorhergehenden Ansprüche, bei der in jedem der genannten Adreßdecoder (40) der jeweilige Decodierungsabschnitt (1, 2) davon ein Decodierungsgate (22, 23, 24, 25, 28) umfaßt, welchem die genannten Adreßsignale zugeführt werden, und Transfergates (20, 26), die durch eine Ausgangssignal von dem genannten Decodierungsgate gesteuert werden.

8. Halbleiterspeichervorrichtung nach Anspruch 7, bei der das genannten Decodierungsgate (22, 23, 24, 25, 28) ein NOR-Gate ist, welches eine Vielzahl von Invertertransistoren umfaßt, die parallel . zueinander angeschlossen sind und jeweils Gateelektroden haben, die angeschlossen sind, um entsprechende Adreßsignale zu empfangen.

9. Halbleiterspeichervorrichtung nach Anspruch 7 oder, bei der die Steuersignale, die den gemeinsamen Steuerleitungen (CD) zugeführt werden, über die genannten Transfergates (20, 26) zu den genannten Klammerabschnitten (3, 4) übertragen werden, und Ausgangssignale der genannten Klammerabschnitte (3, 4) den Steuergates der jeweiligen Gateelemente (5 bis 12) zugeführt werden, die zwischen jeweiligen der genannten Bitleitungen (BL) und jeweiligen Datenbussen (DB), die jenen Bitleitungen zugeordnet sind, verbunden sind.

10. Halbleiterspeichervorrichtung nach Anspruch 9, in Verbindung mit Anspruch 6, bei der die genannten Ausgangssignale der genannten Klammerschaltungen (3, 4) den genannten Steuergates der jeweiligen Gateelemente (5, bis 12) über Bypass-Leitungen (CL0, CL1) zugeführt werden, die zwischen den Leseverstärkern (SA) angeordnet sind.

11. Halbleiterspeichervorrichtung nach einem der vorhergehenden Ansprüche, bei der in jedem der genannten Adreßdecoder (40) jeder der genannten Klammerabschnitte (3, 4) davon Transistoren (32, 33, 35, 36) umfaßt, deren Gates und Drains kreuzweise gekoppelt sind.

**Revendications**

1. Dispositif de mémoire à semiconducteur comprenant un substrat semiconducteur sur lequel est formée une rangée d'amplificateurs de détection (SA), connectés à des paires respectives de fils de bit (BL), et un ensemble de décodeurs d'adresse (40), comprenant chacun une partie de décodage (1, 2), pour décoder les signaux d'adresse qui lui sont fournis au moyen de fils de sélection d'adresse (A) communs du dispositif, et deux parties de verrouillage (3, 4) pour verrouiller les signaux de sortie respectifs de la partie de décodage, l'ensemble des décodeurs d'adresse (40) étant disposés le long de la rangée d'amplificateurs de détection (SA), des décodeurs d'adresse différents étant associés respectivement à des groupes différents des amplificateurs de détection et pouvant être chacun sélectionnés séparément, au moyen des fils de sélection d'adresse communs (A), pour sélectionner de la sorte le groupe associé des amplificateurs de détection, caractérisé en ce que chacun des groupes comprend un ensemble de jeux (SA21/SA22, SA23/SA24) d'amplificateurs de détection différents, les jeux différents d'amplificateurs de détection étant associés activement respectivement à des bus de données différents (DB0, DB1) du dispositif, et en ce que le dispositif comprend des fils de commande communs (CD1, CD0), dont au moins un (CD0) est placé d'un côté de la rangée d'amplificateurs de détection (SA) et un autre (CD1) est placé de l'autre côté de cette rangée, des amplificateurs de détection respectifs (SA21, SA23) correspondants dans les jeux différents du groupe sélectionné pouvant être de la sorte sélectionnés simultanément, de sorte que les signaux de sortie respectifs de ces amplificateurs de détection sélectionnés sont appliqués simultanément aux bus de données respectifs (DB0, DB1) associés, et en ce que le dispositif comprend en outre un ensemble de paires de fils intérieurs communs (C₁, CL0, C₂, CL1) associés activement à des décodeurs respectifs des décodeurs d'adresse (40), chacune des paires étant connectée pour transférer les signaux de sortie de la partie de décodage (1, 2) du décodeur d'adresse (40) associé à celle-ci aux parties de verrouillage respectives (3, 4) de celui-ci et elle est disposée de telle sorte que les fils respectifs de cette paire sont disposés des deux côtés des amplificateurs de détection (SA) du groupe d'amplificateurs de détection associé au décodeur d'adresse (40) concerné.

2. Dispositif de mémoire à semiconducteur selon la revendication 1, dans lequel les fils de commande communs comprennent deux fils de signaux de commande (CD0, DC1) dont un est associé activement à un des amplificateurs de détection dans chaque jeu et dont l'autre est associé activement à un autre des amplificateurs de détection dans chaque jeu.

3. Dispositif de mémoire à semiconducteur selon la revendication 2, dans lequel chacun des groupes comprend deux jeux (SA21/SA22, SA23/SA24) d'amplificateurs de détection, chaque jeu comprenant deux amplificateurs de détection, et dans lequel une paire séparée des bus de données (DB0/$\overline{DB0}$, DB1/$\overline{DB1}$) est prévue pour chaque jeu.

4. Dispositif de mémoire à semiconducteur selon la revendication 2, dans lequel chacun des groupes comprend quatre jeux d'amplificateurs de détection (Figure 4), chaque jeu comprenant deux amplificateurs de détection, et dans lequel une paire séparée des bus de données est prévue pour chaque jeu.

5. Dispositif de mémoire à semiconducteur selon l'une quelconque des revendications 1 à 4, où, dans chacun des décodeurs d'adresse (40) sa partie de décodage respective (1, 2) est divisée en deux sections de circuit, une de ces sections étant placée d'un côté de la rangée d'amplificateurs de détection (SA) et dont l'autre section est placée de l'autre côté de cette rangée.

6. Dispositif de mémoire à semiconducteur selon la revendication 5, où dans chacun des décodeurs d'adresse (40) une de ses parties de verrouillage respectives (3, 4) est placée d'un côté de la rangée d'amplificateurs de détection (SA) et l'autre partie de verrouillage est placée de l'autre côté de cette rangée.

7. Dispositif de mémoire à semiconducteur selon l'une quelconque des revendications 1 à 6, où, dans chacun des décodeurs d'adressse (40), la partie de décodage respective (1, 2) de celui-ci comprend une porte de décodage (22, 23, 24, 25, 28) à laquelle sont appliqués les signaux d'adresse, et des portes de transfert (20, 26) qui sont commandées par un signal de sortie de porte de décodage.

8. Dispositif de mémoire à semiconducteur selon la revendication 7, dans lequel la porte de décodage (22, 23, 24, 25, 28) est une porte NI comprenant un ensemble de transistors inverseurs qui sont connectés en parallèle entre eux et ont des électrodes de grille respectives connectées pour recevoir des signaux d'adresse respectifs.

9. Dispositif de mémoire à semiconductbur selon l'une quelconque des revendications 7 et 8 dans lequel les signaux de commande fournis aux fils de commande communs (CD) sont transférés aux parties de verrouillage (3,4) par l'intermédiaire des portes de transfert (20, 26), et les signaux de sortie des parties de verrouillage (3, 4) sont fournis aux grilles de commande d'éléments à grille respectifs (5 à 12) connectés entre des fils respectifs des fils de bit (BL) et les bus de données respectifs (DB) associés à ces fils de bit.

10. Dispositif de mémoire à semiconducteur selon la revendication 9 telle que dépendante de la revendication 6, dans lequel les signaux de sortie des parties de verrouillage (3, 4) sont fournis aux grilles de commande des éléments à grille respectifs (5 à 12) au moyen de fils de contournement (CL0, CL1) disposés entre les amplificateurs de détection (SA).

11. Dispositif de mémoire à semiconducteur selon l'une quelconque des revendications 1 à 10, où, dans chacun des décodeurs d'adresse (40) chacune des parties de verrouillage (3, 4) de celui-ci comprend des transistors (32, 33, 35, 36) qui sont en couplage croisé par leurs grilles et leurs drains.

0 079 220

Fig 1

| Fig. IA | Fig. IB |

Fig. IA

# Fig. 1B

# Fig. 2

# Fig. 3A

Fig. 3A

# Fig. 3B.

Fig. 4A

Fig. 4

| Fig. 4A | Fig. 4B |

# Fig. 4B